# EUROPEAN PATENT APPLICATION

(11) **EP 4 704 149 A1**
(43) Date of publication of application: **04.03.2026**
(21) Application number: 23938010.8
(22) Date of filing: 25.05.2023
(51) Int. Cl.: H01L 23/367, H01L 23/31

(54) **HEAT DISSIPATION COVER, CHIP PACKAGING STRUCTURE AND ELECTRONIC DEVICE**

(71) Applicant: Huawei Technologies Co., Ltd., Shenzhen, Guangdong 518129 (CN)
(72) Inventor: CHEN, Jinyu, Shenzhen, Guangdong 518129 (CN); GUO, Qing, Shenzhen, Guangdong 518129 (CN); ZUO, Rui, Shenzhen, Guangdong 518129 (CN); XIONG, Wei, Shenzhen, Guangdong 518129 (CN); LU, Jun, Shenzhen, Guangdong 518129 (CN); LV, Jianbiao, Shenzhen, Guangdong 518129 (CN); ZHENG, Jiantao, Shenzhen, Guangdong 518129 (CN)
(74) Representative: Pfenning, Meinig & Partner mbB
(86) International application number: PCT/CN2023/096387
(87) International publication number: WO 2024/239339

(57) **Abstract**

Embodiments of this application provide a heat dissipating lid, a chip package structure, and an electronic device, and relate to the field of heat dissipation technologies, to facilitate heat dissipation for a chip. The heat dissipating lid includes a first surface configured to be connected to the chip, and a groove located on the first surface. The first surface includes a first contact region. In the chip package structure, a boundary of an orthographic projection of the chip on the first surface coincides with a boundary of the first contact region. The groove is located outside the first contact region and connected to the first contact region, and the groove is provided extending along at least a portion of the boundary of the first contact region. The heat dissipating lid is applicable to the chip package structure and configured to dissipate heat for the chip.

## Description

### TECHNICAL FIELD

This application relates to the field of heat dissipation technologies, and in particular, to a heat dissipating lid, a chip package structure, and an electronic device.

### BACKGROUND

With development of chip technologies, power and densities of chips continuously increase. A large amount of heat is generated in a working process of the chips, affecting performance and service life of the chips.

Usually, a heat dissipating lid (heat dissipating lid, HDL) is employed to cover the chip, and a thermal interface material is disposed between the chip and the heat dissipating lid, so that heat dissipation is implemented for the chip through the thermal interface material and the heat dissipating lid. A solder thermal interface material (solder thermal interface material, S-TIM) is commonly used as the thermal interface material.

However, with the use of the solder thermal interface material, there is a problem of high thermal resistance of a contact surface between the solder thermal interface material and the chip. This is not conducive to heat dissipation for the chip.

### SUMMARY

Embodiments of this application provide a heat dissipating lid, a chip package structure, and an electronic device, to facilitate heat dissipation for a chip.

To achieve the foregoing objectives, the following technical solutions are used in embodiments of this application.

According to a first aspect, a heat dissipating lid is provided. The heat dissipating lid is applicable to a chip package structure and configured to dissipate heat for a chip. The heat dissipating lid includes a first surface configured to be connected to the chip, and a groove located on the first surface. The first surface includes a first contact region. In the chip package structure, a boundary of an orthographic projection of the chip on the first surface coincides with a boundary of the first contact region. The groove is located outside the first contact region and connected to the first contact region, and the groove is provided extending along at least a portion of the boundary of the first contact region.

According to the heat dissipating lid provided in the foregoing embodiment of this application, the heat dissipating lid includes the first surface configured to be connected to the chip, and the first surface includes the first contact region corresponding to the chip. The groove is provided on the first surface, the groove is located outside the first contact region and connected to the first contact region, and the groove is provided extending along at least a portion of the boundary of the first contact region. In a process of preparing the chip package structure, a sheet-like solder thermal interface material and the heat dissipating lid are successively disposed above the chip. The sheet-like solder thermal interface material melts during soldering, and under a capillary flow effect, a portion of the solder thermal interface material in a liquid state flows into the groove for storage.

In a subsequent preparing and manufacturing process, a high temperature causes a wing region of the chip to warp so that a surface of the wing region of the chip is high, and causes the cured solder thermal interface material to melt again. The solder thermal interface material in the liquid state flows away from the wing region of the chip. Because the groove is connected to the first contact region, the solder thermal interface material stored in the groove flows to the first contact region and flows to a surface of the chip under the capillary flow effect, and fills in the wing region of the chip. After the solder thermal interface material in the liquid state is cured, the solder thermal interface material can fully cover the chip to reduce thermal resistance of a contact surface between the solder thermal interface material and the chip, thereby facilitating heat dissipation for the chip.

In some embodiments, the groove is an annular groove and surrounds the first contact region. In this way, a substantial portion of the solder thermal interface material may be stored through the groove, and the solder thermal interface material stored in the groove flows to the surface of the chip under the capillary flow effect, so that the solder thermal interface material fills in all wing regions of the chip.

Alternatively, a groove section design is employed for the groove, the groove includes at least one groove section, the first contact region includes a corner region, and each groove section is located outside one corner region and provided along a boundary of the corner region. In the wing region of the chip, warping is severer in a corner portion. The solder thermal interface material stored in the groove section flows to the corner portion of the chip under the capillary flow effect, and the solder thermal interface material may cover the corner portion of the chip after being cured.

In some embodiments, a shape of an orthographic projection of the groove section on the first surface is an L shape or a sector.

In some embodiments, the groove includes a side surface connected to the first contact region, and a minimum included angle between the side surface of the groove and the first surface is a right angle. For example, the first surface is horizontally disposed, and the side surface of the groove is vertically arranged, so that the solder thermal interface material that has melted into the liquid state flows out along the side surface of the groove under the capillary flow effect and an effect of gravity, and flows to the first contact region to fill in the wing region of the chip. After the solder thermal interface material in the liquid state is cured, it is ensured that the first thermal interface material layer can fully cover the chip.

Alternatively, a minimum included angle between the side surface of the groove and the first surface is an obtuse angle, that is, the side surface of the groove tilts toward the first contact region.

In the process of preparing the chip package structure, the tilted side surface may guide the solder thermal interface material to flow to the first contact region and fill in the wing region of the chip. After the solder thermal interface material in the liquid state is cured, the solder thermal interface material can fully cover the chip.

In some embodiments, a shape of a cross section of the groove along a reference surface is any one of a rectangle, a trapezoid, a semicircle, or a triangle, and the reference surface is perpendicular to the first surface and perpendicular to a length extension direction of the groove.

In some embodiments, a width range of the groove is 0.1 mm to 5 mm, and a depth range of the groove is 100 µm to 500 µm.

According to a second aspect, a chip package structure is provided. The chip package structure includes a chip, a thermal interface material layer, and the heat dissipating lid in any one of the foregoing embodiments. The thermal interface material layer is disposed on the chip, and the heat dissipating lid is disposed on a side that is of the thermal interface material layer and that is away from the chip.

In the chip package structure provided in the foregoing embodiment of this application, the heat dissipating lid includes a first surface on a side that is close to the chip, and the first surface is connected to the chip through the thermal interface material layer. The first surface includes a first contact region, and a boundary of an orthographic projection of the chip on the first surface coincides with a boundary of the first contact region. In other words, the first surface includes the first contact region corresponding to the chip.

A groove is provided on the first surface of the heat dissipating lid, and the groove is located outside the first contact region and is provided extending along at least a portion of the boundary of the first contact region. In a process of preparing the chip package structure, the groove is configured to store the excess of a solder thermal interface material.

In a subsequent preparing and manufacturing process, a high temperature causes a wing region of the chip to warp so that a surface of the wing region of the chip is high, the high temperature also causes the solder thermal interface material to melt, and the solder thermal interface material in a liquid state flows away from the wing region of the chip. The solder thermal interface material stored in the groove flows to a surface of the chip under a capillary flow effect, and fills in the wing region of the chip. After the solder thermal interface material is cured, it is ensured that the solder thermal interface material layer can fully cover the chip, to reduce thermal resistance of a contact surface between the solder thermal interface material and the chip, thereby facilitating heat dissipation for the chip.

In some embodiments, the chip package structure further includes a metal connection layer. The metal connection layer is located between the heat dissipating lid and the thermal interface material layer, and covers the first contact region and a surface of the groove.

In the foregoing embodiment, the metal connection layer has proper wetness, that is, the solder thermal interface material in the liquid state has a strong capability of spreading on a surface of the metal connection layer. The solder thermal interface material in the liquid state flows in regions that are of the metal connection layer and that correspond to the first contact region and the groove, so that the solder thermal interface material in the liquid state flows into the groove for storage or flows to the surface of the chip, to fill in the wing region of the chip and form the thermal interface material layer covering the chip.

In some embodiments, the metal connection layer includes one first part and a plurality of second parts, the first part includes a plurality of corners, and each second part is connected to one corner of the first part, so that the metal connection layer has an unconventional shape.

A shape of an orthographic projection of the first part on the first surface is the same as a shape of the first contact region, and the first part covers the first contact region, to help the solder thermal interface material in the liquid state to flow in a region that is of the first part and that corresponds to the first contact region, so that the solder thermal interface material in the liquid state flows to the surface of the chip and fills in the wing region of the chip.

The groove includes a plurality of groove sections, the plurality of second parts are in a one-to-one correspondence with the plurality of groove sections, a shape of an orthographic projection of the second part on the first surface is the same as a shape of an orthographic projection of the groove section on the first surface, and the second part covers a surface of a corresponding groove section. This helps the solder thermal interface material in the liquid state to flow in a region that is of the second part and that corresponds to the corresponding groove section, thereby helping to store the solder thermal interface material in the liquid state into the groove section.

In some embodiments, the shapes of the orthographic projections of the second part and the groove section on the first surface are both L shapes, or the shapes of the orthographic projections of the second part and the groove section on the first surface are both sectors.

In some embodiments, a material of the metal connection layer includes at least one of copper, aluminum, titanium, or a nickel-vanadium alloy.

In some embodiments, the orthographic projection of the chip on the first surface is within a range of an orthographic projection of the thermal interface material layer on the first surface. In other words, the orthographic projection of the thermal interface material layer on the first surface covers the orthographic projection of the chip on the first surface.

It may be understood that, when the solder thermal interface material stored in the groove melts, one portion of the solder thermal interface material flows to the surface of the chip under the capillary flow effect and fills in the wing region of the chip, and the other portion of the solder thermal interface material flows to a side surface of the chip under an effect of gravity. After the solder thermal interface material is cured to form the thermal interface material layer, the orthographic projection of the chip on the first surface is within the range of the orthographic projection of the thermal interface material layer on the first surface.

In some embodiments, the thermal interface material layer covers a portion that is of the side surface of the chip and that is close to the first surface.

In some embodiments, a material of the thermal interface material layer includes at least one of an indium alloy, an indium-silver alloy, a tin-silver-copper alloy, or a tin-bismuth-silver alloy.

According to a third aspect, an electronic device is provided. The electronic device includes a chip package structure and a circuit board, and the chip package structure is electrically connected to the circuit board.

It may be understood that, for beneficial effects that can be achieved by the electronic device provided in the foregoing embodiments of this application, reference may be made to the beneficial effects of the heat dissipating lid in the foregoing descriptions. Details are not described herein.

### BRIEF DESCRIPTION OF DRAWINGS

To describe technical solutions in this application more clearly, the following briefly describes accompanying drawings for describing some embodiments of this application. It is apparent that the accompanying drawings in the following descriptions are merely accompanying drawings in some embodiments of this application. For a person of ordinary skill in the art, other drawings may also be derived from these accompanying drawings. In addition, the accompanying drawings in the following descriptions may be considered as diagrams, and are not intended to limit an actual size of a product, an actual procedure of a method, an actual time sequence of a signal, and the like in embodiments of this application.
FIG. 1 is a diagram of a structure of a server according to an embodiment of this application;
FIG. 2 is a diagram of a structure of a chip heat dissipation system according to an embodiment of this application;
FIG. 3 is a bottom view of a heat dissipating lid according to an embodiment of this application;
FIG. 4 is a sectional view of the heat dissipating lid in FIG. 3 along a section line A-A';
FIG. 5 is a partial enlarged view of the heat dissipating lid in FIG. 4 at a position M;
FIG. 6 is a structural diagram of a chip package structure according to an embodiment of this application;
FIG. 7 is a bottom view of another heat dissipating lid according to an embodiment of this application;
FIG. 8 is a sectional view of the heat dissipating lid in FIG. 7 along a section line B-B';
FIG. 9 is a partial enlarged view of the heat dissipating lid in FIG. 8 at a position N;
FIG. 10 to FIG. 12 are sectional views of grooves of a plurality of heat dissipating lids according to embodiments of this application; and
FIG. 13 to FIG. 16 are bottom views of a plurality of heat dissipating lids according to embodiments of this application.

### DESCRIPTION OF EMBODIMENTS

The following clearly and completely describes the technical solutions in some embodiments of this application with reference to the accompanying drawings. It is clear that the described embodiments are merely some rather than all of embodiments of this application. All other embodiments obtained by a person of ordinary skill in the art based on embodiments of this application shall fall within the protection scope of this application.

In the descriptions of this application, it should be understood that directions or position relationships indicated by the terms such as "center", "up", "down", "front", "rear", "left", "right", "vertical", "horizontal", "top", "bottom", "inside", and "outside" are based on the directions or the position relationships shown in the accompanying drawings, and are merely intended to describe this application and simplify the descriptions, but not intended to indicate or imply that an indicated apparatus or component shall have a specific direction or be formed and operated in a specific direction, and therefore cannot be understood as any limitation on this application.

Unless otherwise required in the context, throughout the specification and claims, the term "include" is interpreted as "open and inclusive", that is, "include but not limited to". In the description of the specification, terms such as "an embodiment", "some embodiments", "example embodiments", "examples", or "some examples" are intended to indicate that specific features, structures, materials, or characteristics related to the embodiment or examples are included in at least one embodiment or example of this application. The foregoing schematic representations of the terms do not necessarily mean a same embodiment or example. Further, the particular feature, structure, material, or characteristic may be included in any one or more embodiments or examples in any appropriate manner.

The terms "first" and "second" mentioned below are merely intended for a purpose of description, and shall not be understood as an indication or implication of relative importance or implicit indication of a quantity of indicated technical features. Therefore, a feature limited by "first" or "second" may explicitly or implicitly include one or more features. In the descriptions of embodiments of this application, unless otherwise specified, "a plurality of" means two or more than two.

In the description of some embodiments, expressions of "connection" and extensions thereof may be used. For example, when some embodiments are described, the term "connection" may indicate that two or more components are in direct physical contact or electrical contact with each other. Embodiments of this application herein are not necessarily limited to content of this specification.

"A and/or B" includes the following three combinations: only A, only B, and a combination of A and B.

The use of "configured to" in this specification implies an open and inclusive language, and does not exclude a device that is applicable to or configured to perform an additional task or step.

In addition, the use of "based on" means openness and inclusiveness, since processes, steps, computing, or other actions "based on" one or more of conditions or values in practice may be based on additional conditions or values outside the described values.

Example implementations are described with reference to sectional views and/or plan views that are used as idealized example accompanying drawings. In the accompanying drawings, for clarity, thicknesses of layers and regions are increased. Thus, a change in a shape in the accompanying drawings due to, for example, manufacturing techniques and/or tolerances may be envisaged. Therefore, example implementations should not be construed as being limited to a shape of a region shown herein, but rather include shape deviations due to, for example, manufacturing. For example, an etching region shown as a rectangle typically has a bending characteristic. Therefore, regions shown in the accompanying drawings are essentially examples, and their shapes are not intended to show actual shapes of regions of a device, and are not intended to limit a scope of the example implementations.

Some embodiments of this application provide an electronic device. The electronic device may be a supercomputer, an in-vehicle device, a smart home device, and/or a smart city device, a server, a workstation, a data center, or the like. A specific type of the electronic device is not specially limited in embodiments of this application.

For ease of description, the following uses an example in which the electronic device is a server for description. Embodiments of this application are not limited thereto.

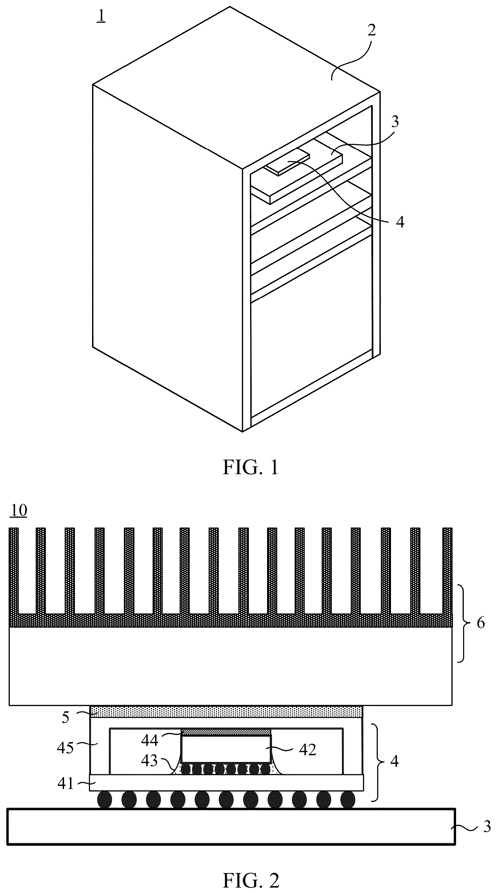

FIG. 1 is a diagram of a structure of a server according to an embodiment of this application.

As shown in FIG. 1, the server 1 includes a cabinet 2, and a circuit board 3 and a chip package structure 4 that are disposed in the cabinet 2. The chip package structure 4 includes a chip and a structure for packaging the chip. The chip package structure 4 is disposed on the circuit board 3 and electrically connected to the circuit board 3. The circuit board 3 includes but is not limited to a printed circuit board (printed circuit board, PCB).

With development of chip technologies, power and densities of chips continuously increase. A large amount of heat is generated in a working process of the chips, affecting performance and a service life of the chips. To implement heat dissipation for the chip, a structure used to dissipate heat for the chip is usually disposed in the server 1. The structure used to dissipate heat for the chip, together with the chip and the circuit board, forms a chip heat dissipation system. FIG. 2 is a diagram of a structure of a chip heat dissipation system according to an embodiment of this application.

Refer to FIG. 2. The chip heat dissipation system 10 includes a circuit board 3 and a chip package structure 4. The chip package structure 4 is connected to the circuit board 3 through a bonding structure.

For example, the bonding structure usually includes a solder bump (solder bump), a solder ball (solder ball), or a copper pillar (Cu pillar). For example, the chip package structure 4 is connected to the circuit board 3 through the solder ball.

The chip package structure 4 may use a package design of a flip chip ball grid array (flip chip ball grid array, FC-BGA). The chip package structure 4 includes a package substrate 41 and a chip 42. The chip 42 is disposed on the package substrate 41, and is connected to the package substrate 41 through the bonding structure.

For example, the chip 42 is connected to the package substrate 41 through the solder bump. A filling layer 43 is further disposed at the bottom of the chip 42, and the filling layer 43 is located between the chip 42 and the package substrate 41, and wraps the solder bump, to improve strength of the connection between the chip 42 and the package substrate 41.

A structure of the chip package structure 4 provided in this embodiment of this application is not limited to the foregoing design.

Refer to FIG. 2 again. The chip package structure 4 further includes a first thermal interface material layer 44 and a heat dissipating lid (heat dissipating lid, HDL) 45. The first thermal interface material layer 44 is disposed on the chip 42, and the heat dissipating lid 45 is disposed on a side that is of the first thermal interface material layer 44 and that is away from the chip 42. The chip 42 generates much heat in an operating process, and the heat may be spread out through the first thermal interface material layer 44 and the heat dissipating lid 45, to implement heat dissipation for the chip 42.

For example, the heat dissipating lid 45 may be a copper lid (copper lid), a micro-fluidic channel lid (micro-fluidic channel lid, MCL), a vapor chamber lid (vapor chamber lid, VCL), or the like.

For example, a material of the heat dissipating lid 45 may include copper.

For example, the heat dissipating lid 45 may be bonded to the package substrate 41 through a binder.

Refer to FIG. 2. The chip heat dissipation system 10 further includes a second thermal interface material layer 5 and a heat sink 6. The second thermal interface material layer 5 is disposed on the heat dissipating lid 45, and the heat sink 6 is disposed on a side that is of the second thermal interface material layer 5 and that is away from the heat dissipating lid 45. Heat on the heat dissipating lid 45 may be spread out through the second thermal interface material layer 5 and the heat sink 6, thereby further improving heat dissipation efficiency of the chip 42.

The first thermal interface material layer 44 and the second thermal interface material layer 5 both include a thermal interface material (thermal interface material, TIM). In comparison with a carbon-based or silicon-based thermal interface material, a solder thermal interface material (solder thermal interface material, S-TIM) has better thermal conductivity and mechanical performance. For example, the solder thermal interface material includes at least one of indium (chemical formula: In), indium-silver alloy (chemical formula: InAg), and tin-silver-copper alloy (chemical formula: SnAgCu), or a tin-bismuth-silver alloy (chemical formula: SnBiAg). Therefore, the first thermal interface material layer 44 and the second thermal interface material layer 5 may employ the solder thermal interface material, to help improve the heat dissipation efficiency of the chip 42 and improve connection strength of the structure.

However, in a process of preparing the chip heat dissipation system 10, some process steps need to be performed in a high-temperature environment, and a high temperature may cause warping of the chip 42. Generally, a wing region of the chip 42 is severely warped. In addition, the high temperature further causes the first thermal interface material layer 44 to melt into a solder thermal interface material in a liquid state. Because the wing region of the chip 42 is severely warped, a surface of the wing region of the chip 42 is high, and the solder thermal interface material in the liquid state flows away from the wing region of the chip 42. After the solder thermal interface material is cured again, the first thermal interface material layer 44 formed cannot fully cover the chip 42. Consequently, thermal resistance of a contact surface between the first thermal interface material layer 44 and the chip 42 increases. This is not conducive to heat dissipation for the chip 42.

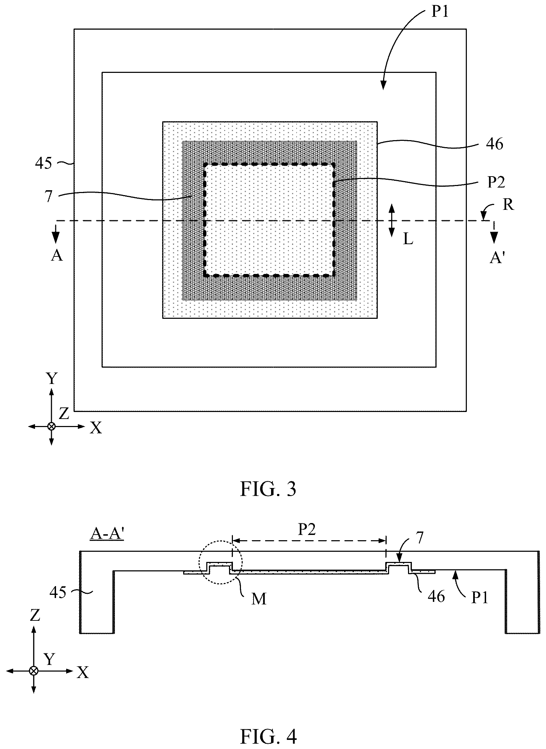

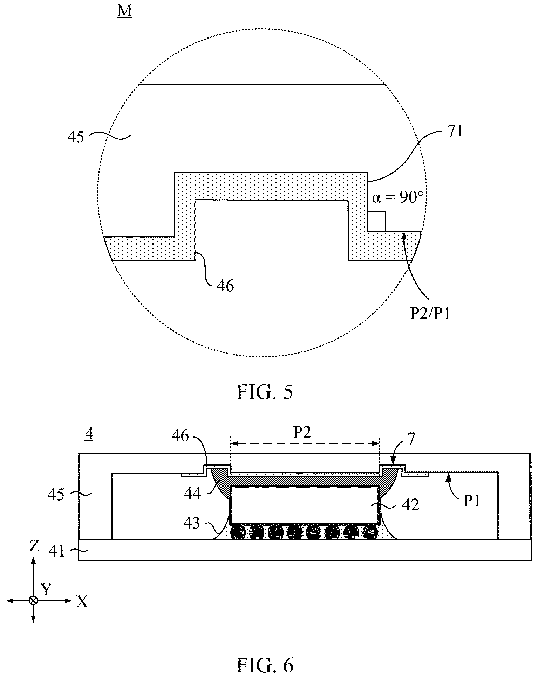

To resolve the foregoing problem, some embodiments of this application provide a heat dissipating lid. FIG. 3 is a bottom view of a heat dissipating lid according to an embodiment of this application. FIG. 4 is a sectional view of the heat dissipating lid in FIG. 3 along a section line A-A'. FIG. 5 is a partial enlarged view of the heat dissipating lid in FIG. 4 at a position M. FIG. 6 is a structural diagram of a chip package structure according to an embodiment of this application.

Refer to FIG. 3 to FIG. 6. The chip package structure 4 includes a chip 42, a first thermal interface material layer 44, and a heat dissipating lid 45. The first thermal interface material layer 44 is disposed on the chip 42, the heat dissipating lid 45 is disposed on a side that is of the first thermal interface material layer 44 and that is away from the chip 42. The heat dissipating lid 45 includes a first surface P1 on a side that is close to the chip 42, and a groove 7 located on the first surface P1.

It may be understood that the first surface P1 of the heat dissipating lid 45 is a bottom surface of the heat dissipating lid 45, the bottom surface of the heat dissipating lid 45 is provided with the groove 7, and the bottom surface of the heat dissipating lid 45 is configured to be connected to the chip 42. For example, the bottom surface of the heat dissipating lid 45 is connected to the chip 42 through the first thermal interface material layer 44.

There may be a plurality of methods for preparing the groove 7. For example, in this embodiment of this application, a photoetching process may be used. First, a photoresist layer is formed on the bottom surface of the heat dissipating lid 45, and then exposure and development processing is performed on the photoresist layer, so that only a region in which the groove 7 is located is exposed in the photoresist layer. Finally, the photoresist layer is used as a mask to etch the bottom surface of the heat dissipating lid 45, to form the groove 7.

For example, a width range of the groove 7 is 0.1 mm to 5 mm. For example, a width of the groove 7 is 0.1 mm, 1 mm, 2.5 mm, 4 mm, or 5 mm.

For example, a depth range of the groove 7 is 100 µm to 500 µm. For example, a depth of the groove 7 is 100 µm, 200 µm, 300 µm, 400 µm, or 500 µm.

Refer to FIG. 3 to FIG. 6. The first surface P1 of the heat dissipating lid 45 includes a first contact region P2. In the chip package structure 4, a boundary of an orthographic projection of the chip 42 on the first surface P1 coincides with a boundary of the first contact region P2. To be specific, in a thickness direction Z of the chip package structure 4, the chip 42 corresponds to the first contact region P2 of the heat dissipating lid 45.

It may be understood that a shape of the orthographic projection of the chip 42 on the first surface P1 is the same as a shape of the first contact region P2, and areas of the two are equal.

For example, the shape of the orthographic projection of the chip 42 on the first surface P1 is a rectangle, and the shape of the first contact region P2 is also a rectangle. FIG. 3 shows a case in which the first contact region P2 is a rectangle. Embodiments of this application are not limited thereto. The shape of the first contact region P2 may be adjusted based on the shape of the orthographic projection of the chip 42 on the first surface P1, so that the shape of the first contact region P2 is the same as that of the chip 42.

Refer to FIG. 3 to FIG. 6. On the first surface P1 of the heat dissipating lid 45, the groove 7 is located outside the first contact region P2 and connected to the first contact region P2, and the groove 7 is provided extending along at least a portion of the boundary of the first contact region P2.

It may be understood that, as shown in FIG. 3, the groove 7 has edges close to the first contact region P2 and edges away from the first contact region P2. The edges of the groove 7 that are close to the first contact region P2 coincide with at least a portion of the boundary of the first contact region P2.

For example, as shown in FIG. 3, the groove 7 is an annular groove, the groove 7 surrounds the first contact region P2, the groove 7 is provided along all boundaries of the first contact region P2, and the edges of the groove 7 that are close to the first contact region P2 coincide with all boundaries of the first contact region P2.

In the chip package structure 4 provided in the foregoing embodiments of this application, the heat dissipating lid 45 includes the first surface P1 on a side that is close to the chip 42, and the first surface P1 is connected to the chip 42 through the first thermal interface material layer 44. The first surface P1 includes the first contact region P2, and the boundary of the orthographic projection of the chip 42 on the first surface P1 coincides with the boundary of the first contact region P2, that is, the bottom surface of the heat dissipating lid 45 has the first contact region P2 corresponding to the chip 42.

The groove 7 is provided on the first surface P1 of the heat dissipating lid 45, the groove 7 is located outside the first contact region P2 and connected to the first contact region P2, and the groove 7 is provided extending along at least a portion of the boundary of the first contact region P2. In a process of preparing the chip package structure 4, a sheet-like solder thermal interface material and the heat dissipating lid 45 are successively disposed above the chip 42, and the sheet-like solder thermal interface material melts during soldering. Under a capillary flow effect, a portion of the solder thermal interface material in the liquid state flows into the groove 7 for storage. After the solder thermal interface material in the liquid state is cured, the first thermal interface material layer 44 surrounding the chip 42 is formed.

In a subsequent preparing and manufacturing process, for example, in a process step of bottom ball mount (Ball Mount, BM) of the package substrate 41 in the chip package structure 4, or in a process step of bonding the package substrate 41 of the chip package structure 4 to the circuit board 3 through a surface mount technology (surface mount technology, SMT), a high temperature causes warping of a wing region of the chip 42 so that a surface of the wing region of the chip 42 is high, and the high temperature also causes the first thermal interface material layer 44 to melt. The solder thermal interface material in the liquid state flows away from the wing region of the chip 42. Because the groove 7 is connected to the first contact region P2, the solder thermal interface material stored in the groove 7 flows to the first contact region P2 and flows to a surface of the chip 42 under the capillary flow effect, and fills in the wing region of the chip 42. After the solder thermal interface material in the liquid state is cured, it is ensured that the first thermal interface material layer 44 can fully cover the chip 42 to reduce thermal resistance of a contact surface between the first thermal interface material layer 44 and the chip 42, thereby facilitating heat dissipation for the chip 42.

Further, the groove 7 surrounds the first contact region P2, that is, the groove 7 is provided along all boundaries of the first contact region P2. In this way, a substantial portion of the solder thermal interface material may be stored through the groove 7, so that the solder thermal interface material fills in all wing regions of the chip 42.

In some embodiments, as shown in FIG. 6, the orthographic projection of the chip 42 on the first surface P1 is within a range of an orthographic projection of the first thermal interface material layer 44 on the first surface P1. In other words, the orthographic projection of the first thermal interface material layer 44 on the first surface P1 covers the orthographic projection of the chip 42 on the first surface P1.

It may be understood that, when the solder thermal interface material stored in the groove 7 melts, one portion of the solder thermal interface material flows to the surface of the chip 42 under the capillary flow effect and fills in the wing region of the chip 42, and the other portion of the solder thermal interface material flows to a side surface of the chip 42 under an effect of gravity. After the solder thermal interface material is cured to form the first thermal interface material layer 44, the orthographic projection of the chip 42 on the first surface P1 is within the range of the orthographic projection of the first thermal interface material layer 44 on the first surface P1.

For example, a boundary of the orthographic projection of the first thermal interface material layer 44 on the first surface P1 goes beyond a boundary of the orthographic projection of the chip 42 on the first surface P1.

For example, the first thermal interface material layer 44 includes a middle portion located between the chip 42 and the heat dissipating lid 45 and an edge portion surrounding the middle portion. The middle portion corresponds to the chip 42 and the first contact region P2, and is configured to conduct heat generated by the chip 42 to the heat dissipating lid 45. The edge portion of the first thermal interface material layer 44 covers a side surface of the chip 42 (a portion that is of the side surface and that is close to the first surface P1, namely, a portion that is of the side surface and that is close to the top of the chip 42), to protect the middle portion and reduce an oxidation rate of the middle portion, to ensure heat conduction performance of the middle portion, thereby ensuring long-term reliability of heat dissipation for the chip 42.

In some embodiments, as shown in FIG. 3 to FIG. 6, the chip package structure 4 further includes a metal connection layer 46. The metal connection layer 46 is located between the heat dissipating lid 45 and the first thermal interface material layer 44, and covers the first contact region P2 and a surface of the groove 7 of the heat dissipating lid 45.

For example, a material of the metal connection layer 46 includes at least one of copper (chemical formula: Au), aluminum (chemical formula: Al), titanium (chemical formula: Ti), or a nickel-vanadium alloy (chemical formula: NiV), and the metal connection layer 46 with an even thickness may be formed in the first contact region P2 and on the surface of the groove 7 of the heat dissipating lid 45 by using an electroplating process.

For example, as shown in FIG. 3, a boundary of an orthographic projection of the metal connection layer 46 on the first surface P1 goes beyond an outer boundary of the groove 7. In some other examples, the boundary of the orthographic projection of the metal connection layer 46 on the first surface P1 may alternatively coincide with the outer boundary of the groove 7.

In the process of preparing the chip package structure 4, a sheet-like solder thermal interface material is disposed above the chip 42. Usually, the orthographic projection of the metal connection layer 46 on the first surface P1 is within a range of an orthographic projection of the sheet-like solder thermal interface material on the first surface P1. In other words, the sheet-like solder thermal interface material covers the metal connection layer 46, and the sheet-like solder thermal interface material melts during soldering, so that the solder thermal interface material in the liquid state fully covers a surface of the metal connection layer 46.

The metal connection layer 46 has proper wetness, that is, the solder thermal interface material in the liquid state has a strong capability of spreading on the surface of the metal connection layer 46. The metal connection layer 46 is disposed to cover the first contact region P2 and the surface of the groove 7, to help the solder thermal interface material in the liquid state to flow in regions that are of the metal connection layer 46 and that correspond to the first contact region P2 and the groove 7, so that the solder thermal interface material in the liquid state flows into the groove 7 for storage or flows to the surface of the chip 42, to fill in the wing region of the chip 42 and form the first thermal interface material layer 44 covering the chip 42.

In some embodiments, as shown in FIG. 5 and FIG. 6, the groove 7 includes a side surface 71 connected to the first contact region P2, and a minimum included angle α between the side surface 71 of the groove 7 and the first surface P1 is a right angle (α = 90°).

For example, the first surface P1 is parallel to a plane X-Y, and the side surface 71 of the groove 7 is parallel to the direction Z and perpendicular to the first surface P1.

For example, in the process of preparing the chip package structure 4, the first surface P1 is horizontally disposed, and the side surface 71 of the groove 7 is vertically arranged, so that the solder thermal interface material that melts into the liquid state flows out of the side surface 71 of the groove 7 under the capillary flow effect and the effect of gravity, and flows to the first contact region P2 along the surface of the metal connection layer 46, to fill in the wing region of the chip 42. After the solder thermal interface material in the liquid state is cured, it is ensured that the first thermal interface material layer 44 can fully cover the chip 42.

For example, a shape of a cross section of the groove 7 along a reference surface R is a rectangle. As shown in FIG. 3, the reference surface R is perpendicular to the first surface P1 and perpendicular to a length extension direction L of the groove 7.

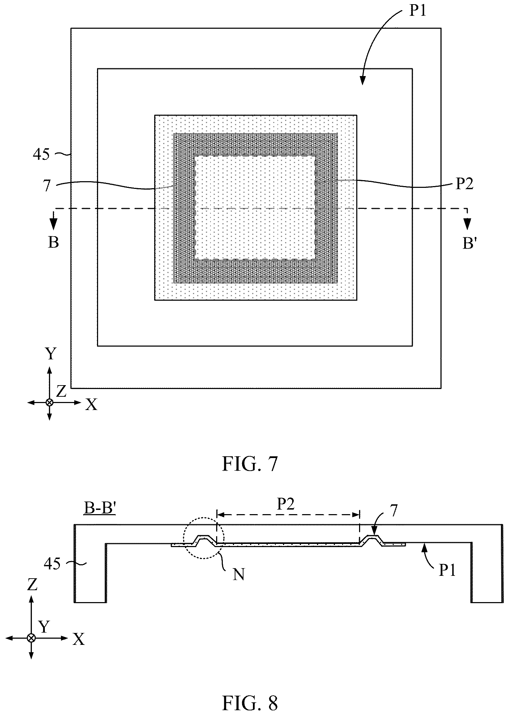

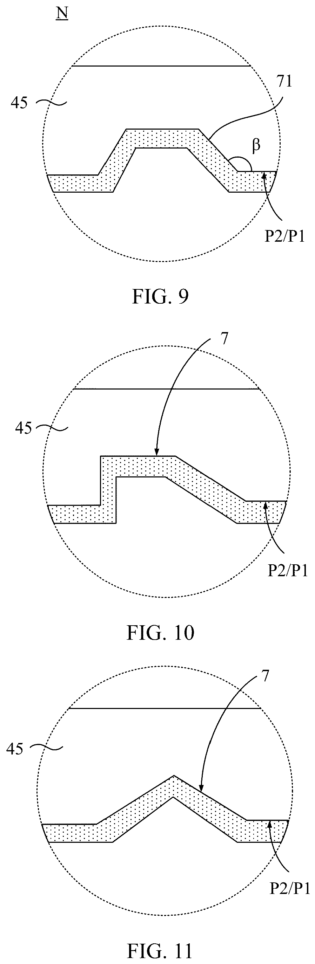

FIG. 7 is a bottom view of another heat dissipating lid according to an embodiment of this application. FIG. 8 is a sectional view of the heat dissipating lid in FIG. 7 along a section line B-B'. FIG. 9 is a partial enlarged view of the heat dissipating lid in FIG. 8 at a position N.

Refer to FIG. 7 to FIG. 9. A minimum included angle β between the side surface 71 of the groove 7 and the first surface P1 is an obtuse angle (90° < β < 180°), that is, the side surface 71 of the groove 7 tilts toward the first contact region P2, and the tilted side surface 71 may guide the solder thermal interface material to flow to the first contact region P2 (to flow on the surface of the metal connection layer 46), and fill in the wing region of the chip 42. After the solder thermal interface material in the liquid state is cured, it is ensured that the first thermal interface material layer 44 can fully cover the chip 42.

For example, as shown in FIG. 9, the shape of the cross section of the groove 7 along the reference surface R is a trapezoid. For example, the shape of the cross section of the groove 7 is an isosceles trapezoid.

FIG. 10 to FIG. 12 are sectional views of grooves of a plurality of heat dissipating lids according to embodiments of this application.

Refer to FIG. 10. The shape of the cross section of the groove 7 along the reference surface R is a right-angle trapezoid.

Refer to FIG. 11. The shape of the cross section of the groove 7 along the reference surface R is a triangle.

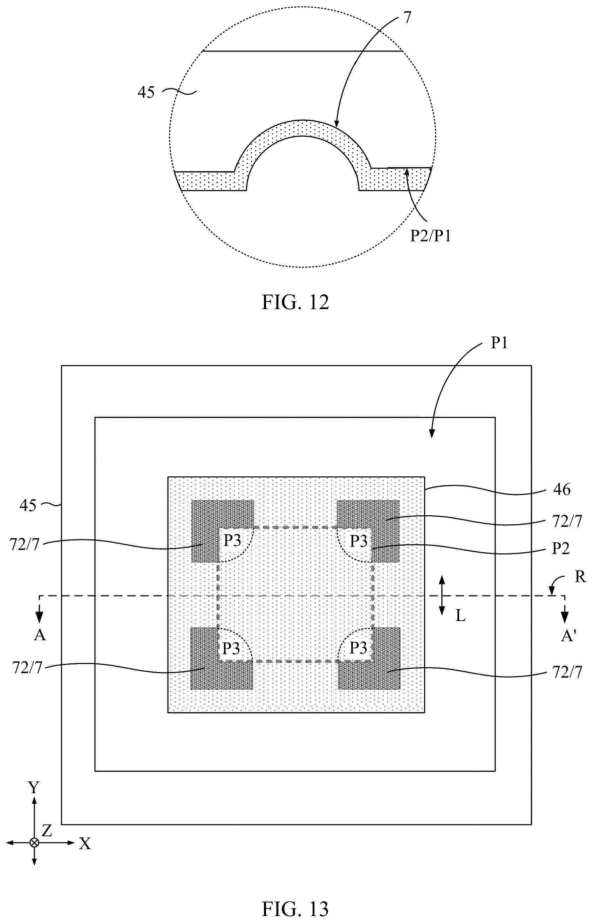

Refer to FIG. 12. The shape of the cross section of the groove 7 along the reference surface R is a semicircle.

In embodiments of this application, the cross-sectional shape of the groove 7 is not limited thereto.

FIG. 13 to FIG. 16 are bottom views of a plurality of heat dissipating lids according to embodiments of this application.

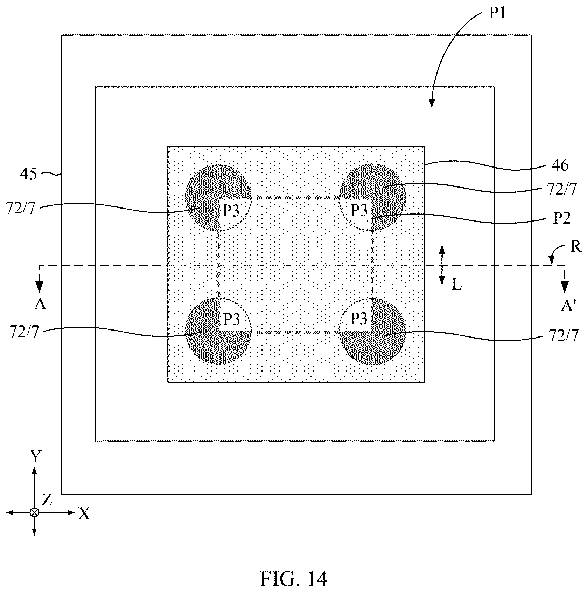

Refer to FIG. 13 and FIG. 14. The first contact region P2 includes a corner region P3. For ease of display and description, in the figure, a range of the corner region P3 is represented by using dashed circles as an example, but a contour shape of the corner region P3 is not limited thereto.

In the foregoing description, the chip 42 corresponds to the first contact region P2 of the heat dissipating lid 45. Therefore, a corner portion of the chip 42 corresponds to the corner region P3 of the first contact region P2.

Refer to FIG. 13 and FIG. 14 again. The groove 7 includes a plurality of groove sections 72, each groove section 72 is located outside each corner region P3 of the first contact region P2, and each groove section 72 is provided along a boundary of the corner region P3. The groove 7 is designed in a manner of groove sections, and the groove 7 does not surround the first contact region P2.

For example, the shape of the orthographic projection of the chip 42 on the first surface P1 is a rectangle, the shape of the first contact region P2 is also a rectangle, and the first contact region P2 has four corner regions P3. In this case, the groove 7 includes four groove sections 72, and each groove section 72 corresponds to one corner region P3.

For example, as shown in FIG. 13, a shape of an orthographic projection of the groove section 72 on the first surface P1 is an L shape.

For example, as shown in FIG. 14, the shape of the orthographic projection of the groove section 72 on the first surface P1 is a sector.

It may be understood that, in the wing region of the chip 42, warping is severer in the corner portion. When the first thermal interface material layer 44 melts, the solder thermal interface material in the liquid state easily flows away from the corner portion of the chip 42 under the effect of gravity. After the solder thermal interface material in the liquid state is cured, the first thermal interface material layer 44 cannot cover the corner portion of the chip 42.

On this basis, the groove section 72 is provided on the first surface P1 of the heat dissipating lid 45, each groove section 72 is located outside each corner region P3 of the first contact region P2, and each groove section 72 is provided along the boundary of the corner region P3. In the process of preparing the chip package structure 4, during soldering, a portion of the solder thermal interface material in the liquid state flows, under the capillary flow effect, into the groove section 72 for storage.

In a subsequent preparing and manufacturing process, the corner portion of the chip 42 is warped, the solder thermal interface material in the liquid state flows away from the corner portion of the chip 42, and the solder thermal interface material stored in the groove section 72 flows to the corner portion of the chip 42 under the capillary flow effect. After the solder thermal interface material in the liquid state is cured, it is ensured that the first thermal interface material layer 44 can cover the corner portion of the chip 42.

In conclusion, it can be learned that in embodiments of this application, a design of an annular groove or groove sections may be employed for the groove 7.

In addition, there may be a plurality of pattern designs for the metal connection layer 46.

Refer to FIG. 13 and FIG. 14. The metal connection layer 46 may have a conventional shape. For example, the metal connection layer 46 is a rectangle, a circle, or the like.

Alternatively, the metal connection layer 46 may have an unconventional shape.

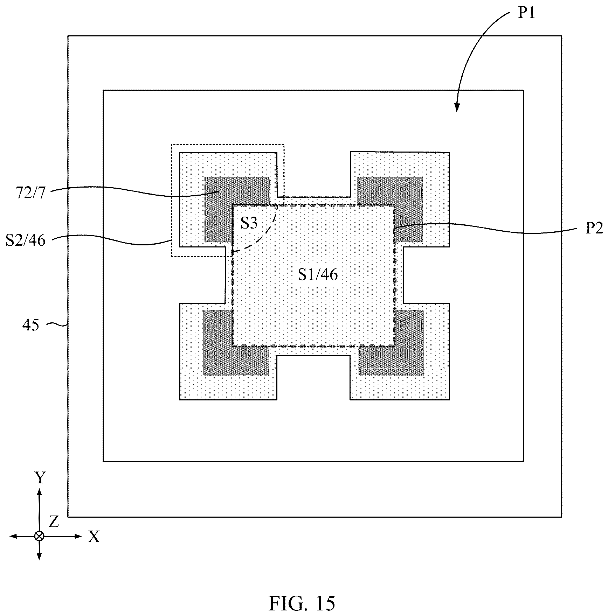

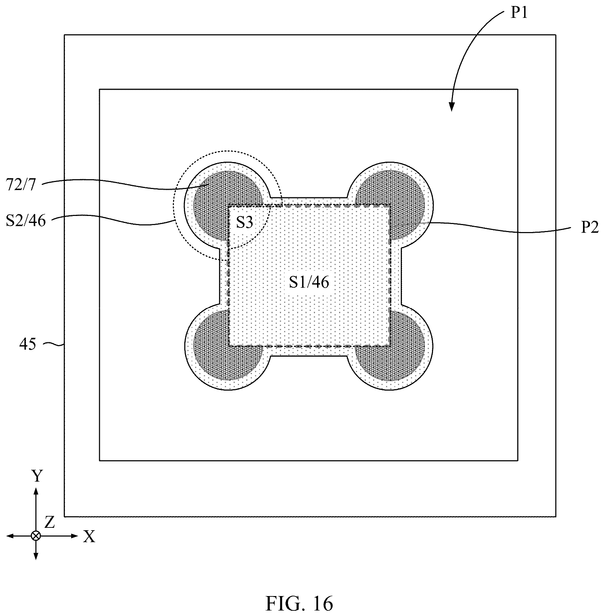

Refer to FIG. 15 and FIG. 16. The metal connection layer 46 includes one first part S1 and a plurality of second parts S2, the first part S1 includes a plurality of corners S3, and each second part S2 is connected to one corner S3 othe first part S1.

A shape of an orthographic projection of the first part S1 on the first surface P1 of the heat dissipating lid 45 is the same as the shape of the first contact region P2. In addition, the first part S1 covers the first contact region P2.

The shape of the orthographic projection of the chip 42 on the first surface P1 is the same as the shape of the first contact region P2, and areas of the two are equal. Therefore, the shape of the orthographic projection of the first part S1 on the first surface P1 is the same as the shape of the orthographic projection of the chip 42 on the first surface P1, and the orthographic projection of the first part S1 on the first surface P1 covers the orthographic projection of the chip 42 on the first surface P1.

For example, the orthographic projection of the chip 42 on the first surface Pl is a rectangle, the shape of the first contact region P2 is a rectangle, and the orthographic projection of the first part S1 on the first surface P1 is also a rectangle.

The first part S1 of the metal connection layer 46 is disposed to cover the first contact region P2, to help the solder thermal interface material in the liquid state to flow in a region that is of the first part S1 and that corresponds to the first contact region P2, so that the solder thermal interface material in the liquid state flows to the surface of the chip 42 and fills in the wing region of the chip 42.

Refer to FIG. 15 and FIG. 16 again. When the groove 7 is designed in a manner of groove sections, the plurality of second parts S2 of the metal connection layer 46 are in a one-to-one correspondence with the plurality of groove sections 72 of the groove 7, and a shape of an orthographic projection of the second part S2 on the first surface P1 is the same as the shape of the orthographic projection of the groove section 72 on the first surface P1. In addition, the second part S2 covers a surface of the corresponding groove section 72.

For example, as shown in FIG. 15, the shape of the orthographic projection of the groove section 72 on the first surface P1 is an L shape, and the shape of the orthographic projection of the second part S2 on the first surface P1 is also an L shape.

For example, as shown in FIG. 16, the shape of the orthographic projection of the groove section 72 on the first surface P1 is a sector, and the shape of the orthographic projection of the second part S2 on the first surface P1 is also a sector.

The second part S2 of the metal connection layer 46 is disposed to cover the surface of the groove section 72, to help the solder thermal interface material in the liquid state to flow in a region that is of the second part S2 and that corresponds to the groove section 72, so that the solder thermal interface material in the liquid state flows into the groove section 72 for storage.

According to the heat dissipating lid provided in embodiments of this application, the heat dissipating lid includes the first surface (bottom surface) configured to be connected to the chip, and the first surface of the heat dissipating lid has the first contact region corresponding to the chip. The groove is provided on the first surface of the heat dissipating lid, and the groove is located outside the first contact region and is provided extending along at least a portion of the boundary of the first contact region. In the process of preparing the chip package structure, the groove is configured to store the excess of the solder thermal interface material.

In a subsequent preparing and manufacturing process, a high temperature causes the wing region of the chip to warp so that the surface of the wing region of the chip is high, the high temperature also causes the solder thermal interface material to melt, and the solder thermal interface material in the liquid state flows away from the wing region of the chip. The solder thermal interface material stored in the groove flows to the surface of the chip under the capillary flow effect, and fills in the wing region of the chip. The solder thermal interface material can fully cover the chip after being cured, to reduce thermal resistance of the contact surface between the solder thermal interface material and the chip, thereby facilitating heat dissipation for the chip.

In addition, the groove may be designed in a manner of an annular groove or groove sections. When the groove is an annular groove, the groove surrounds the first contact region, and a substantial portion of the solder thermal interface material may be stored through the groove, so that the solder thermal interface material fills in all wing regions of the chip. When the groove is in the manner of groove sections, each groove section is provided in each corner region of the first contact region, and the corner portion of the chip is more prone to warping. The solder thermal interface material stored in the groove section flows to the corner portion of the chip under the capillary flow effect, and the solder thermal interface material may cover the corner portion of the chip after being cured.

In addition, the groove includes the side surface connected to the first contact region, and the minimum included angle between the side surface of the groove and the first surface is an obtuse angle. For example, the cross sectional shape of the groove may be a trapezoid, a semicircle, or a triangle. The side surface of the groove tilts toward the first contact region. The tilted side surface may guide the solder thermal interface material to flow to the first contact region, and the solder thermal interface material may fully cover the chip after being cured.

For beneficial effects that can be achieved by the chip package structure and the electronic device provided in embodiments of this application, refer to the beneficial effects of the heat dissipating lid. Details are not described herein.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chip package structure, comprising:
a chip;
a thermal interface material layer, disposed on the chip; and
a heat dissipating lid, disposed on a side that is of the thermal interface material layer and that is away from the chip, wherein
the heat dissipating lid comprises a first surface on a side that is close to the chip, and a groove that is located on the first surface; and
the first surface comprises a first contact region, a boundary of an orthographic projection of the chip on the first surface coincides with a boundary of the first contact region, the groove is located outside the first contact region and connected to the first contact region, and the groove is provided extending along at least a portion of the boundary of the first contact region.

2. The chip package structure according to claim 1, wherein the groove surrounds the first contact region; or the first contact region comprises a corner region, the groove comprises at least one groove section, and the groove section is located outside the corner region and provided along a boundary of the corner region.

3. The chip package structure according to claim 1 or 2, wherein the groove comprises a side surface connected to the first contact region, and a minimum included angle between the side surface of the groove and the first surface is a right angle or an obtuse angle.

4. The chip package structure according to claim 3, wherein a shape of a cross section of the groove along a reference surface is any one of a rectangle, a trapezoid, a semicircle, or a triangle; and
the reference surface is perpendicular to the first surface and perpendicular to a length extension direction of the groove.

5. The chip package structure according to any one of claims 1 to 4, wherein the chip package structure further comprises a metal connection layer, located between the heat dissipating lid and the thermal interface material layer; and
the metal connection layer covers the first contact region and a surface of the groove.

6. The chip package structure according to claim 5, wherein the metal connection layer comprises one first part and a plurality of second parts, the first part comprises a plurality of corners, and each second part is connected to one corner of the first part;
a shape of an orthographic projection of the first part on the first surface is the same as a shape of the first contact region, and the first part covers the first contact region; and
the groove comprises a plurality of groove sections, the plurality of second parts are in a one-to-one correspondence with the plurality of groove sections, a shape of an orthographic projection of the second part on the first surface is the same as a shape of an orthographic projection of the groove section on the first surface, and the second part covers a surface of a corresponding groove section.

7. The chip package structure according to claim 6, wherein the shapes of the orthographic projections of the second part and the groove section on the first surface are both L shapes; or
the shapes of the orthographic projections of the second part and the groove section on the first surface are both sectors.

8. The chip package structure according to any one of claims 5 to 7, wherein a material of the metal connection layer comprises at least one of copper, aluminum, titanium, or a nickel-vanadium alloy.

9. The chip package structure according to any one of claims 1 to 8, wherein the orthographic projection of the chip on the first surface is within a range of an orthographic projection of the thermal interface material layer on the first surface.

10. The chip package structure according to claim 9, wherein the thermal interface material layer covers a portion that is of a side surface of the chip and that is close to the first surface.

11. The chip package structure according to any one of claims 1 to 10, wherein a material of the thermal interface material layer comprises at least one of indium, an indium-silver alloy, a tin-silver-copper alloy, or a tin-bismuth-silver alloy.

12. The chip package structure according to any one of claims 1 to 11, wherein a width range of the groove is 0.1 mm to 5 mm; and
a depth range of the groove is 100 µm to 500 µm.

13. A heat dissipating lid, wherein the heat dissipating lid comprises a first surface and a groove located on the first surface, and the first surface is configured to be connected to a chip;
the first surface comprises a first contact region, and a boundary of an orthographic projection of the chip on the first surface coincides with a boundary of the first contact region; and
the groove is located outside the first contact region, and is provided extending along at least a portion of the boundary of the first contact region.

14. The heat dissipating lid according to claim 13, wherein the groove surrounds the first contact region; or
the first contact region comprises a corner region, the groove comprises at least one groove section, and the groove section is located outside the corner region and provided along a boundary of the corner region.

15. The heat dissipating lid according to claim 14, wherein a shape of an orthographic projection of the groove section on the first surface is an L shape or a sector.

16. The heat dissipating lid according to any one of claims 13 to 15, wherein the groove comprises a side surface connected to the first contact region, and a minimum included angle between the side surface of the groove and the first surface is a right angle or an obtuse angle.

17. The heat dissipating lid according to claim 16, wherein a shape of a cross section of the groove along a reference surface is any one of a rectangle, a trapezoid, a semicircle, or a triangle; and
the reference surface is perpendicular to the first surface and perpendicular to a length extension direction of the groove.

18. The heat dissipating lid according to any one of claims 13 to 17, wherein a width range of the groove is 0.1 mm to 5 mm; and
a depth range of the groove is 100 µm to 500 µm.

19. An electronic device, comprising:
the chip package structure according to any one of claims 1 to 12; and
a circuit board, wherein the chip package structure is electrically connected to the circuit board.
